# EUROPEAN PATENT SPECIFICATION

(11) **EP 3 755 125 B1**
(45) Date of publication and mention of the grant of the patent: **18.01.2023**
(21) Application number: 19753667.5
(22) Date of filing: 10.01.2019
(51) Int. Cl.: H05H 1/46, H01J 37/32, H03H 7/00

(54) **ATMOSPHERIC-PRESSURE PLASMA GENERATION DEVICE, ATMOSPHERIC-PRESSURE PLASMA GENERATION CIRCUIT, AND ATMOSPHERIC-PRESSURE PLASMA GENERATION METHOD**
VORRICHTUNG ZUR ERZEUGUNG VON PLASMA BEI ATMOSPHÄRISCHEM DRUCK, SCHALTUNG ZUR ERZEUGUNG VON PLASMA BEI ATMOSPHÄRISCHEM DRUCK UND VERFAHREN ZUR ERZEUGUNG VON PLASMA BEI ATMOSPHÄRISCHEM DRUCK
DISPOSITIF DE GÉNÉRATION DE PLASMA À PRESSION ATMOSPHÉRIQUE, CIRCUIT DE GÉNÉRATION DE PLASMA À PRESSION ATMOSPHÉRIQUE ET PROCÉDÉ DE GÉNÉRATION DE PLASMA À PRESSION ATMOSPHÉRIQUE

(30) Priority: 13.02.2018 JP 2018023413
(43) Date of publication of application: 23.12.2020
(73) Proprietor: FUJIFILM Corporation, Tokyo 106-8620 (JP)
(72) Inventor: IWATA, Mitsuru, ashigara-shi, Kanagawa 250-0193 (JP)
(74) Representative: Klunker IP Patentanwälte PartG mbB
(86) International application number: PCT/JP2019/000503
(87) International publication number: WO 2019/159571

(56) References cited:
- EP-A1- 1 626 613
- WO-A1-2007/024134
- JP-A- 2007 520 878
- JP-A- 2017 130 305
- US-A1- 2005 168 152
- US-A1- 2017 290 137

## Description

### BACKGROUND OF THE INVENTION

### 1. Field of the Invention

The present invention relates to an atmospheric-pressure plasma generation device, an atmospheric-pressure plasma generation circuit, and an atmospheric-pressure plasma generation method that generate plasma under atmospheric pressure.

### 2. Description of the Related Art

There is a case where plasma, such as molecular gas, is used to perform surface treatment (cleaning, activation, substance lamination, or the like) of a film, a semiconductor substrate, or the like. An atmospheric-pressure plasma generation device comprises an alternating-current power supply, and a plasma generation unit having a pair of electrodes connected to the alternating-current power supply, and applies an alternating-current high voltage between the electrodes under atmospheric pressure, thereby converting molecular gas or the like introduced between the electrodes into a plasma state.

There is a case where the atmospheric-pressure plasma generation device generates abnormal discharge (streamer current) in a case where plasma input power (electric power) is increased. For this reason, in the atmospheric-pressure plasma generation device, it is devised to dispose dielectrics on the surfaces of the respective electrodes in the plasma generation unit, thereby suppressing the occurrence of the abnormal discharge using a reverse electric field formed by the dielectrics during generation of plasma.

In recent years, an atmospheric-pressure plasma generation device is known that connects a choke coil to a plasma generation unit, and suppresses a displacement current, resulting in suppressing abnormal discharge (JP2007-520878A (JP4668208B) and JP2006-080060A (JP5459923B)). An atmospheric-pressure plasma generation device is also known that connects a choke coil and an LC circuit with a frequency of a power supply as a resonance frequency to a plasma generation unit, thereby suppressing abnormal discharge (JP2009-506496A (JP5367369B)).

WO2007024134A1 discloses a method and arrangement for generating and controlling a discharge plasma in a discharge space having at least two spaced electrodes. A gas or gas mixture is introduced in the discharge space, and a power supply for energizing the electrodes is provided for applying an AC plasma energizing voltage to the electrodes. At least one current pulse is generated and causes a plasma current and a displacement current. Means for controlling the plasma are provided and arranged to apply a displacement current rate of change for controlling local current density variations associated with a plasma variety having a low ratio of dynamic to static resistance, such as filamentary discharges. EP1626613A1 discloses a method and arrangement for controlling a glow discharge plasma under atmospheric conditions. US2017290137A1 discloses suppression of self pulsing DC driven nonthermal microplasma discharge to operate in a steady dc mode. US2005168152A1 discloses techniques for termination of secondary frequencies in RF power delivery.

### SUMMARY OF THE INVENTION

In the atmospheric-pressure plasma generation device, in a case where the dielectrics are disposed on the electrodes constituting the plasma generation unit, and in a case where plasma input power is increased, a suppression action of the abnormal discharge is insufficient according to the characteristic and thickness of the dielectrics, and the abnormal discharge occurs.

An object of the invention is to provide an atmospheric-pressure plasma generation device, an atmospheric-pressure plasma generation circuit, and an atmospheric-pressure plasma generation method capable of suppressing abnormal discharge and stably generating atmospheric-pressure plasma even though plasma input power is increased.

In one aspect, there is provided an atmospheric-pressure plasma generation circuit according to claim 1 of the appended claims.

It is preferable that the discharge current dispersion circuit disperses the pulse of the discharge current into two or more pulses having the same waveform in a case where the plasma generation unit repeatedly generates the plasma.

It is preferable that the pulse generated later in time out of the two or more pluses dispersed by the discharge current dispersion circuit has a lower frequency.

It is preferable that the discharge current dispersion circuit has impedance to transmit a frequency component of the alternating-current voltage and to reduce a frequency component of the discharge current.

In embodiments, in a case where the discharge current dispersion circuit is one of (i) an LC circuit an (ii) an RLC parallel circuit, the discharge current dispersion circuit comprises an inductor connected in parallel with a capacitor.

In embodiments, in a case where the discharge current dispersion circuit is one of (iii) an LC circuit with a resistor connected in series to the capacitor and (iv) an LC circuit with a resistor connected in series to the inductor, the inductor is connected in series with a capacitor.

It is preferable that the alternating-current voltage has a frequency equal to or higher than 1 kHz and equal to or lower than 1 MHz.

The invention also provides an atmospheric-pressure plasma generation device according to claim 8 of the appended claims.

In one aspect, there is provided an atmospheric-pressure plasma generation method according to claim 9 of the appended claims.

With the atmospheric-pressure plasma generation device, the atmospheric-pressure plasma generation circuit, and the atmospheric-pressure plasma generation method of the invention, it is possible to suppress abnormal discharge and to stably generate atmospheric-pressure plasma even though plasma input power is increased.

### BRIEF DESCRIPTION OF THE DRAWINGS

Fig. 1 is a circuit diagram (atmospheric-pressure plasma generation circuit) of an atmospheric-pressure plasma generation device.
Fig. 2 is a graph of a voltage that is generated by an alternating-current power supply.
Fig. 3 is an explanatory view showing the configuration of a plasma generation unit.
Fig. 4 is a graph of an ideal discharge current that accompanies generation of plasma.
Fig. 5 is a graph of the discharge current accompanied by abnormal discharge.
Fig. 6 is a graph showing impedance of a discharge current dispersion circuit.
Fig. 7 is a graph of a discharge current in a case where the discharge current dispersion circuit is introduced.
Fig. 8 is a graph showing dispersed pulses of the discharge current.
Fig. 9 shows an atmospheric-pressure plasma generation circuit having a discharge current dispersion circuit of a modification example.
Fig. 10 shows an atmospheric-pressure plasma generation circuit having a discharge current dispersion circuit of a modification example.
Fig. 11 shows an atmospheric-pressure plasma generation circuit having a discharge current dispersion circuit of a modification example.
Fig. 12 shows an atmospheric-pressure plasma generation circuit having a discharge current dispersion circuit of a modification example.
Fig. 13 is a graph showing impedance of the discharge current dispersion circuit of the modification example.
Fig. 14 shows an atmospheric-pressure plasma generation circuit having a discharge current dispersion circuit of a modification example.
Fig. 15 is a graph showing dispersed pulses of the discharge current.
Fig. 16 is a graph showing dispersed pulses of the discharge current.
Fig. 17 is a graph showing dispersed pulses of the discharge current.
Fig. 18 is a discharge current dispersion circuit having a capacitor that suppresses harmonics.

### DESCRIPTION OF THE PREFERRED EMBODIMENTS

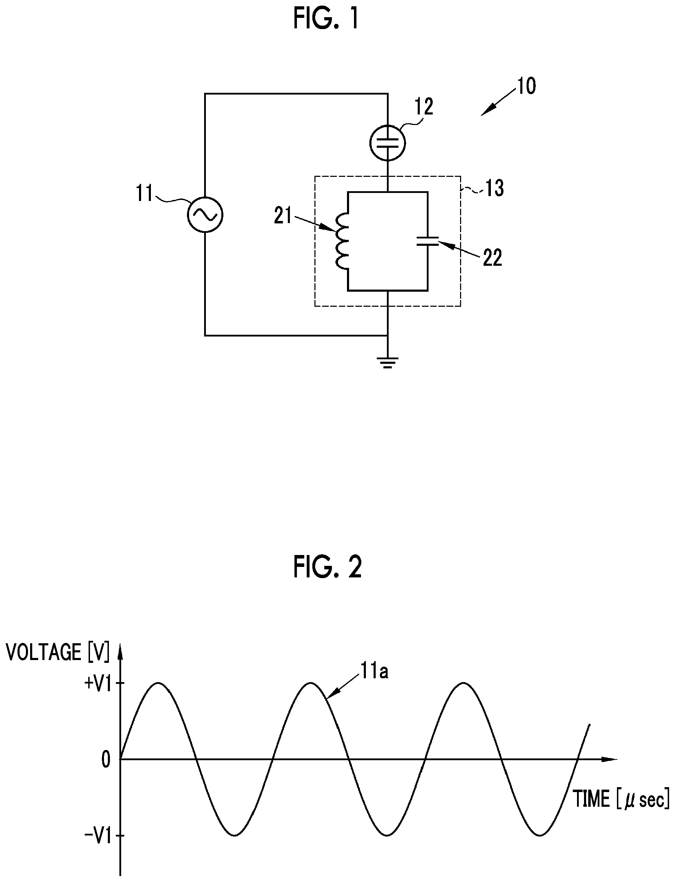

As shown in Fig. 1, an atmospheric-pressure plasma generation device 10 is a device that generates plasma under atmospheric pressure, and comprises an alternating-current power supply 11 that generates an alternating-current voltage having specific amplitude, a plasma generation unit 12 that has a pair of electrodes and generates plasma under atmospheric pressure, and a discharge current dispersion circuit 13 that disperses a pulse of a discharge current generated during the generation of plasma.

The alternating-current power supply 11 generates the alternating-current voltage having a specific frequency and specific amplitude, and supplies the alternating-current voltage to the plasma generation unit 12. The alternating-current power supply 11 includes, in addition to a power supply body that generates a predetermined voltage, at least one of a transformation unit (not shown) that boosts or deboosts the voltage generated by the power supply body to a specific voltage, a matching coil (not shown) that matches impedance, or the like. As shown in Fig. 2, the alternating-current power supply 11 generates, for example, an alternating-current voltage 11a having a sinusoidal waveform. Amplitude V1 of the alternating-current voltage 11a is, for example, about 2000 volts ([V]). A frequency Fac of the alternating-current voltage 11a generated by the alternating-current power supply 11 is, for example, equal to or higher than about 1 kHz and equal to or lower than 1 MHz. That is, the alternating-current voltage 11a generated by the alternating-current power supply 11 has a so-called low frequency. For this reason, the plasma generation unit 12 can ionize not only gas, such as rare gas, consisting of molecules easy to move, but also molecular gas, such as nitrogen, oxygen, or tetraethyl orthosilicate (TEOS), harder to move than rare gas, and can generate plasma.

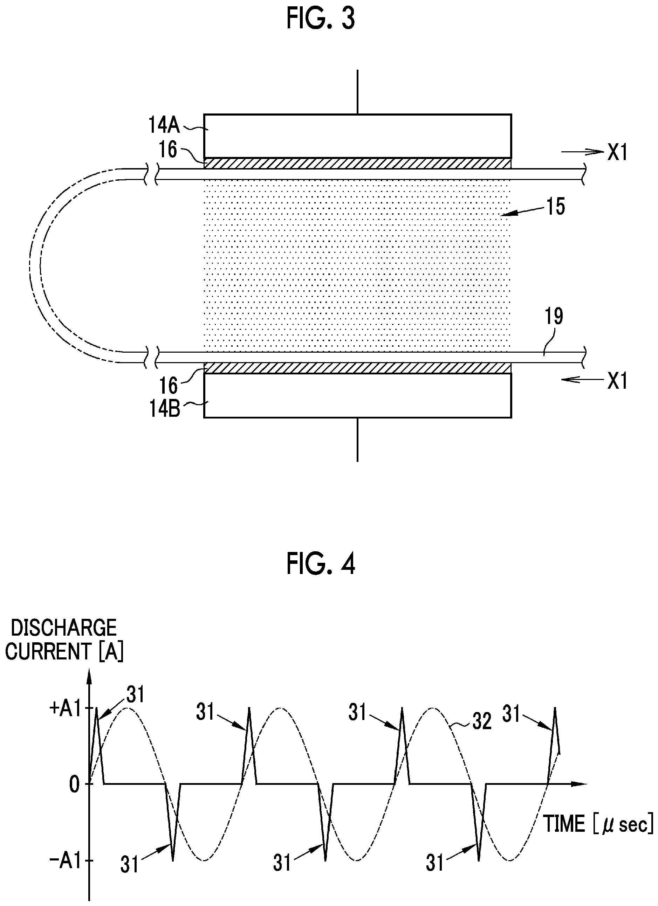

The plasma generation unit 12 has a pair of electrode and generates plasma in a case where the alternating-current voltage 11a is applied between a pair of electrodes under atmospheric pressure. Specifically, as shown in Fig. 3, the plasma generation unit 12 has a pair of electrodes. In the embodiment, a pair of electrodes includes a first electrode 14A and a second electrode 14B. The plasma generation unit 12 forms a discharge space 15 for generating plasma between the first electrode 14A and the second electrode 14B. The atmospheric-pressure plasma generation device 10 has a gas introduction part (not shown), through which gas necessary in surface treatment or the like is introduced into the discharge space 15, and the plasma generation unit 12 generates plasma by ionizing gas, such as TEOS, introduced into the discharge space 15. The plasma generation unit 12 comprises dielectrics 16 on a surface of the first electrode 14A on the discharge space 15 side and a surface of the second electrode 14B on the discharge space 15 side. The dielectrics 16 form an electric field (so-called reverse electric field)) polarized in an opposite direction to polarization of an electric field due to plasma generated in the discharge space. With this, the dielectrics 16 suppress so-called abnormal discharge, such as the generation of a local discharge current, during the generation of plasma.

A target of surface treatment is introduced into the plasma generation unit 12 in contact with the first electrode 14A or the second electrode 14B. In the embodiment, the target of surface treatment is a resin-made film 19, and the atmospheric-pressure plasma generation device 10 transports the film 19 in an X1 direction (transport direction) in contact with the first electrode 14A and the second electrode 14B using a transport roller (not shown) or the like. In the interim, the plasma generation unit 12 generates plasma in the discharge space 15 and treats a surface of the film 19 exposed to the discharge space 15 side using plasma.

During the generation of plasma, a discharge current flows between the first electrode 14A and the second electrode 14B. As shown in Fig. 4, ideally, discharge current pulses 31 are generated at predetermined time intervals while alternately changing polarity according to the alternating-current voltage 11a (in Fig. 4, a phase 32 of the alternating-current voltage 11a is indicated by a broken line) applied between the first electrode 14A and the second electrode 14B each time the alternating-current voltage 11a passes through 0 V generally. Since the alternating-current voltage 11a applied between the first electrode 14A and the second electrode 14B by the alternating-current power supply 11 has a low frequency, the discharge current pulses 31 have a frequency higher than the alternating-current voltage 11a. That is, the discharge current pulses 31 have a frequency Fd higher than the frequency Fac of the alternating-current voltage 11a. The frequency Fd of the discharge current pulses 31 is a frequency of a continuous discharge current pulse 31 on an assumption that any one discharge current pulse 31 is generated continuously, and is an amount generally proportional to a rising shape (slope) of one discharge current pulse 31. Accordingly, the rising shape (slope) of the discharge current pulse 31 is sharper than a rising shape (slope) of a waveform of the alternating-current voltage 11a. In the embodiment, the discharge current pulse 31 has a triangular waveform having amplitude of A1 ampere ([A]), and a discharge current flowing from the first electrode 14A to the second electrode 14B is in a positive direction.

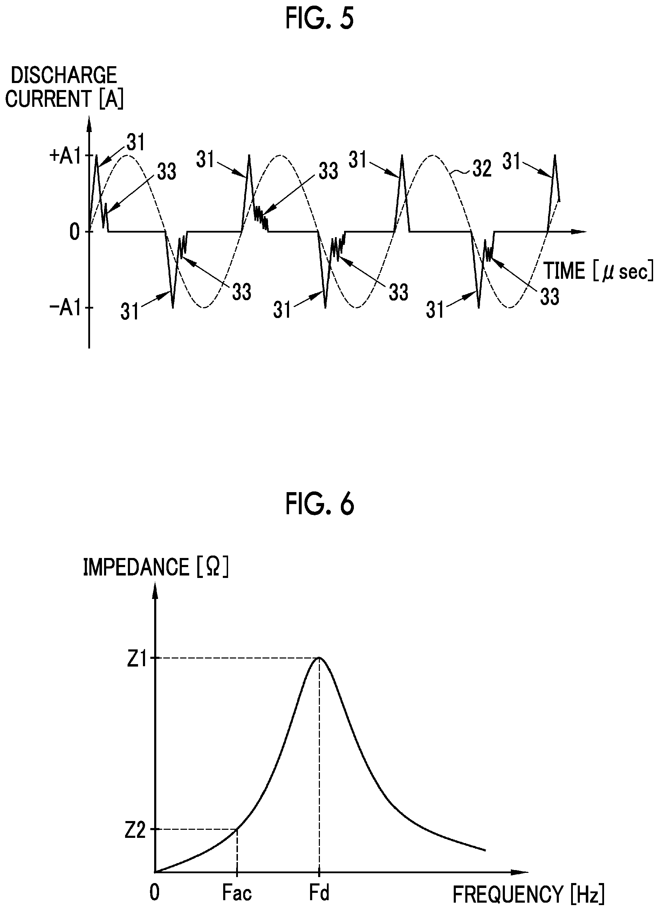

On the other hand, actually, there is a case where abnormal discharge occurs in addition to a normal discharge current that is generated due to the generation of plasma. For example, as shown in Fig. 5, there is a case where a pulse (hereinafter, referred to as an abnormal discharge current pulse) 33 of the discharge current is generated due to abnormal discharge concomitantly at least one of before or after the discharge current pulse 31 due to the normal discharge current. The normal discharge current is generated substantially uniformly in the substantially entire discharge space 15. In contrast, the abnormal discharge is, for example, a discharge current that is locally generated in a part of the discharge space 15. Accordingly, the abnormal discharge current pulse 33 is formed from one or a plurality of pulses due to specific circumstances during the occurrence of the abnormal discharge, such as a position where the abnormal discharge occurs, a range where the abnormal discharge occurs, the number of occurrences of the abnormal discharge, and an occurrence timing of the respective abnormal discharge, and a shape (amplitude or a frequency (a rising shape of the pulse)) or the like of the abnormal discharge current pulse 33 also changes due to the circumstances during the occurrence. Only the discharge current pulse 31 due to the normal discharge current may be generated without the abnormal discharge current pulse 33. That is, whether or not the abnormal discharge current pulse 33 is generated is indeterminate, and even though the abnormal discharge current pulse 33 is generated, the amplitude, frequency, occurrence frequency, or the like of the abnormal discharge current pulse 33 is indeterminate according to circumstances during the generation. In a case where the abnormal discharge that appears as the abnormal discharge current pulse 33 occurs, there is a problem that the surface treatment on the film 19 is not performed uniformly.

Accordingly, in the invention, the discharge current dispersion circuit 13 is connected between the alternating-current power supply 11 and the plasma generation unit 12 (see Fig. 1). The discharge current dispersion circuit 13 is, for example, an LC circuit having an inductor and a capacitor. In the embodiment, the discharge current dispersion circuit 13 is a so-called LC parallel circuit in which an inductor 21 having inductance "L" and a capacitor 22 having capacitance (static capacitance) "C" are connected in parallel, and is connected in series between the alternating-current power supply 11 and the plasma generation unit 12 (see Fig. 1). The discharge current dispersion circuit 13 has a frequency of a discharge current before dispersion formed from one pulse (the frequency Fd of the discharge current pulse 31) as a resonance frequency ω. Specifically, the inductance "L" and the capacitance "C" are balanced such that the resonance frequency ω = 1/(2π√LC) of the discharge current dispersion circuit 13 is substantially equal to the frequency Fd of the discharge current pulse 31 (ω ≈ Fd), and is as far as possible from the frequency Fac of the alternating-current voltage 11a generated by the alternating-current power supply 11 (Fac << ω).

For this reason, as shown in Fig. 6, the discharge current dispersion circuit 13 has generally maximum impedance Z1 with respect to the discharge current pulse 31 having the frequency Fd and has relatively very small impedance Z2 with respect to the alternating-current voltage 11a having the frequency Fac. That is, the discharge current dispersion circuit 13 has impedance to transmit a frequency component of the alternating-current voltage 11a and to reduce a frequency component of the discharge current. Accordingly, the discharge current dispersion circuit 13 functions as a so-called band-stop filter that selectively reduces the amplitude A1 of the discharge current pulse 31. In the embodiment, the resonance frequency ω and the frequency Fd of the discharge current pulse 31 are about 1.7 MHz.

In the atmospheric-pressure plasma generation device 10 (atmospheric-pressure plasma generation circuit), the discharge current dispersion circuit 13 not only simply reduces the amplitude A1 of the discharge current pulse 31, but also stably generates another pulse (hereinafter, referred to as a second discharge current pulse using energy for a reduction amount of the amplitude A1 of the discharge current pulse 31. The term "stably" means that, in a case where the plasma generation unit 12 repeatedly generates plasma, the discharge current dispersion circuit 13 disperses a pulse 31 of an original discharge current, which is generated in a case where the discharge current dispersion circuit 13 is not used, into two or more pulses having the substantially same waveform every time. With this, the discharge current dispersion circuit 13 stabilizes the generation of plasma in the plasma generation unit 12 even though the alternating-current voltage 11a is a high voltage and plasma input power is high.

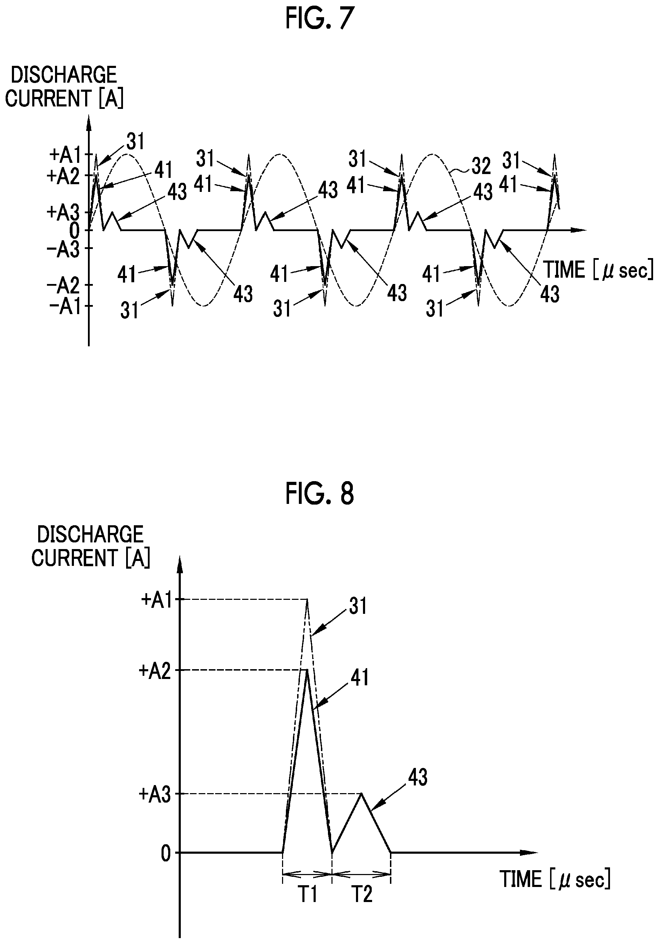

More specifically, as shown in Fig. 7, the discharge current dispersion circuit 13 reduces the discharge current pulse 31 (indicated by a two-dot chain line) having the amplitude A1, which is generated in a case where the discharge current dispersion circuit 13 is not used, to a discharge current pulse 41 (indicated by a solid line) having amplitude A2 (A2 < A1). Similarly to the original discharge current pulse 31, the discharge current pulse 41 after reduction is a pulse due to a normal discharge current that is substantially uniformly generated in the substantially entire discharge space 15 during the generation of plasma.

The discharge current dispersion circuit 13 performs a transient operation as follows during the generation of the discharge current pulse 41 after reduction. First, the alternating-current voltage 11a generated by the alternating-current power supply 11 is substantially transmitted through the inductor 21 in the discharge current dispersion circuit 13 according to a frequency characteristic (Fac << ω) of the alternating-current voltage 11a. For this reason, a high voltage is applied between the first electrode 14A and the second electrode 14B of the plasma generation unit 12. With the application of the high voltage, in the plasma generation unit 12, plasma is generated, and the discharge current pulse 41 according to a discharge amount (current amount) is generated. In this case, in the discharge current dispersion circuit 13, the inductor 21 is not saturated from the beginning (not a so-called choke coil), and the impedance of the inductor 21 is maximized according to change in waveform of the discharge current pulse 31 before reduction generally. At the same time as the maximization of the impedance of the inductor 21, the impedance in the capacitor 22 is also maximized. That is, the inductor 21 and the capacitor 22 are brought into a resonance state of impedance, and joint impedance of the discharge current dispersion circuit 13 is maximized. As a result, the discharge current pulse 31 (amplitude A1) that is scheduled to be generated by the plasma generation unit 12 according to plasma input energy is weakened by the joint impedance of the discharge current dispersion circuit 13 and is reduced to the discharge current pulse 41 having the amplitude A2. After the generation of the discharge current pulse 41, in the plasma generation unit 12, the plasma input energy for the reduction amount is accumulated, and plasma is weakened (or stopped).

The discharge current dispersion circuit 13 generates the second discharge current pulse 43 before or after the discharge current pulse 41. In a case where the plasma generation unit 12 repeatedly generates plasma, that is, in a case where the discharge current pulse 41 is repeatedly generated with inversion of polarity, the second discharge current pulse 43 is generated concomitantly with the discharge current pulse 41 each time the discharge current pulse 41 is generated. The discharge current pulse 41 is a first discharge current pulse in contrast to the second discharge current pulse 43. In the embodiment, the second discharge current pulse 43 is generated concomitantly after the discharge current pulse 41.

During the generation of the second discharge current pulse 43, the discharge current dispersion circuit 13 performs a transient operation as follows. Since the alternating-current voltage 11a is substantially transmitted through the inductor 21 in the discharge current dispersion circuit 13 without change even after the generation of the discharge current pulse 41 (first discharge current pulse), even after the generation of the discharge current pulse 41, the high voltage is continuously applied between the first electrode 14A and the second electrode 14B of the plasma generation unit 12. For this reason, in the plasma generation unit 12, in addition to energy (energy that remains (is accumulated) in the plasma generation unit 12) for the reduction amount in a case where the original discharge current pulse 31 is reduced to the discharge current pulse 41, energy is further accumulated with the continuous application of the high voltage. Then, in a case where total energy exceeds critical energy sufficient for generating plasma, plasma is generated in the plasma generation unit 12 again, and the second discharge current pulse 43 according to the discharge amount (current amount) is generated.

Unlike the abnormal discharge current pulse 33, the second discharge current pulse 43 is a pulse due to the normal discharge current that is substantially uniformly generated in the substantially entire discharge space 15 during the generation of plasma. The second discharge current pulse 43 has the substantially same waveform without depending on the circumstances during the generation. The generation of the second discharge current pulse 43 having the same waveform compensates for plasma for the reduction amount in a case where the original discharge pulse 31 is reduced to the discharge pulse 41. The term "having the same waveform" means that a frequency (a rising or falling shape (slope) of a waveform), a height (amplitude) of a peak, a position of a peak in a pulse, and an energy amount (an area or the like in Fig. 7) are substantially constant excluding change in polarity (positive and negative). In the embodiment, the frequency, amplitude, peak position, and energy amount of the second discharge current pulse 43 are substantially constant in each second discharge current pulse 43 excluding change in polarity. The frequency, amplitude, peak position, and energy amount of the discharge current pulse 41 are substantially constant in each discharge current pulse 41 excluding change in polarity.

In comparison of the original discharge current pulse 31, the discharge current pulse 41 after reduction, and the second discharge current pulse 43, for example, a frequency F1 of the discharge current pulse 41 after reduction is lower than the frequency Fd of the original discharge current pulse 31, and is higher than a frequency F2 of the second discharge current pulse 43 (F2 < F1 < Fd). That is, the pulse generated later in time out of two or more pulses dispersed by the discharge current dispersion circuit 13 has a lower frequency. A slope G1 during rising of the discharge current pulse 41 after reduction is smaller than a slope Gd during rising of the original discharge current pulse 31 and is greater than a slope G2 during rising of the second discharge current pulse 43 (G2 < G1 < Gd).

The energy amount of the second discharge current pulse 43 (an energy amount of plasma causing the second discharge current pulse 43; the same applies to the following) corresponds to an energy amount for the reduction amount in a case where the original discharge current pulse 31 is reduced to the discharge current pulse 41. For example, as shown in Fig. 8, the amplitude of the original discharge current pulse 31 is "A1", the amplitude of the discharge current pulse 41 after reduction is "A2", the amplitude of the second discharge current pulse 43 is "A3", a time for which the original discharge current pulse 31 and the discharge current pulse 41 after reduction are generated is "T1", a time for which the second discharge current pulse 43 is generated is "T2", and change in the alternating-current voltage 11a while the discharge current pulse 41 and the second discharge current pulse 43 are generated (T1+T2) is regarded as very small. In this case, a total of an area ((A2 × Tl)/2) of the discharge current pulse 41, an area (A3 × T2/2)) of the second discharge current pulse 43 is equal to an area ((A1 × Tl)/2) of the original discharge current pulse 31.

Since energy (plasma input power) that is supplied to the plasma generation unit 12 in each cycle of the alternating-current voltage 11a is constant, even though the discharge current dispersion circuit 13 disperses the original discharge current pulse 31 into the discharge current pulse 41 and the second discharge current pulse 43, energy of plasma that is generated in the plasma generation unit 12 is not changed. For this reason, even though the discharge current dispersion circuit 13 disperses the original discharge current pulse 31 into the discharge current pulse 41 and the second discharge current pulse 43, an action amount (cleaning power, substance deposition amount, or the like) in the surface treatment of the film 19 can be maintained.

As described above, the atmospheric-pressure plasma generation device 10 comprises the discharge current dispersion circuit 13 in the circuit. Then, the discharge current dispersion circuit 13 disperses the original discharge current pulse 31, which is generated in a case where the discharge current dispersion circuit 13 is not used, by reducing the original discharge current pulse 31 to the discharge current pulse 41 and generating the second discharge current pulse 43 using energy for a reduction amount.

Usually, the greater the plasma input power is (the greater the amplitude VI of the alternating-current voltage 11a is), the more the abnormal discharge is likely to occur. This is because the greater the plasma input power is, the greater the amplitude A1 of the discharge current pulse 31 becomes. In a case where the amplitude A1 of the discharge current pulse 31 is reduced in order to suppress the occurrence of the abnormal discharge, since energy of generated plasma is lowered as much, the action amount in the surface treatment of the film 19 also decreases.

In contrast, since the atmospheric-pressure plasma generation device 10 of the invention reduce the discharge current pulse 31 to the discharge current pulse 41, the atmospheric-pressure plasma generation device 10 can suppress the occurrence of the abnormal discharge. In addition, the second discharge current pulse 43 is generated using energy for the reduction amount of the discharge current pulse 31. With this, in the plasma generation unit 12, in addition to plasma (first plasma) corresponding to the discharge current pulse 31, stable and uniform second plasma corresponding to the second discharge current pulse 43 is generated. For this reason, a total action amount due to respective plasma is substantially equal to an action amount due to plasma corresponding to the discharge current pulse 31. Considering that the plasma input power is increased, the atmospheric-pressure plasma generation device 10 comprises the discharge current dispersion circuit 13, whereby the atmospheric-pressure plasma generation device 10 can stabilize the generation of plasma while suppressing the abnormal discharge, and as a result, can increase the action amount for an amount corresponding to an amount of increase in plasma input power.

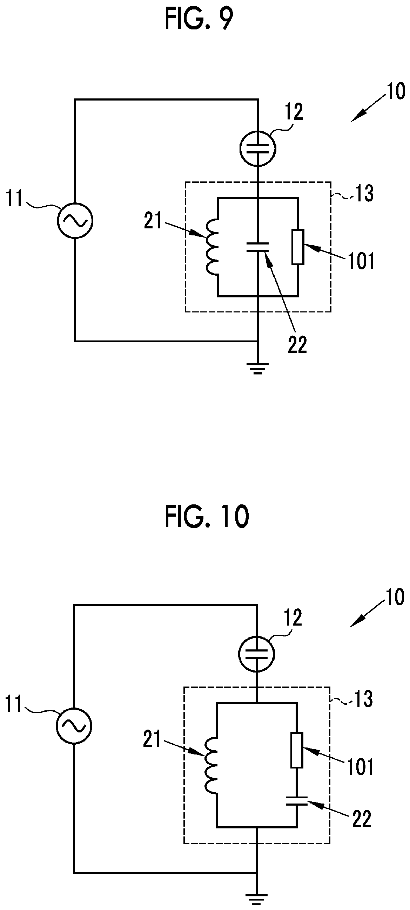

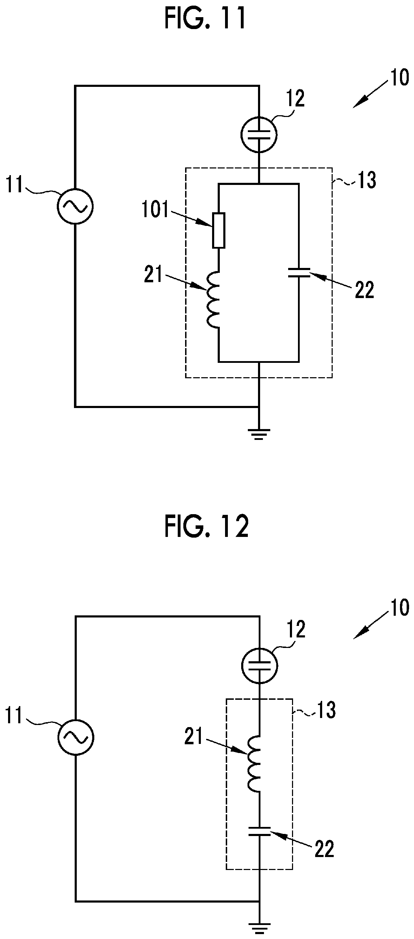

In the above-described embodiment, although the discharge current dispersion circuit 13 is the LC parallel circuit having the inductor 21 and the capacitor 22, as shown in Fig. 9, the discharge current dispersion circuit 13 can be an RLC parallel circuit that further has a resistor 101 having predetermined resistance (R [Ω]). In a case where the discharge current dispersion circuit 13 is the RLC parallel circuit, the action is the same as in the above-described embodiment. In a case where the discharge current dispersion circuit 13 comprises the resistor 101 in addition to the LC parallel circuit, as shown in Fig. 10, the resistor 101 may be connected in series to the capacitor 22. Alternatively, as shown in Fig. 11, the resistor 101 may be connected in series to the inductor 21. That is, the resistor 101 can be added at any position in the discharge current dispersion circuit 13.

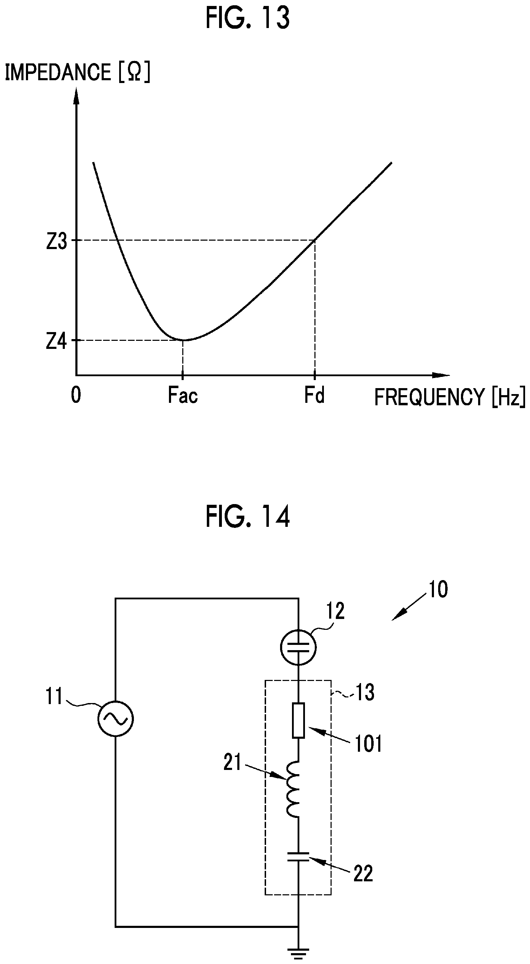

In the above-described embodiment, although the discharge current dispersion circuit 13 is the LC parallel circuit in which the inductor 21 and the capacitor 22 are connected in parallel, as shown in Fig. 12, the discharge current dispersion circuit 13 can be an LC series circuit in which the inductor 21 and the capacitor 22 are connected in series. The discharge current dispersion circuit 13 constituted of the LC series circuit is connected in series between the alternating-current power supply 11 and the plasma generation unit 12. Then, the discharge current dispersion circuit 13 constituted of the LC series circuit has the frequency Fac of the alternating-current voltage 11a as the resonance frequency ω. Specifically, the discharge current dispersion circuit 13 is balanced such that the resonance frequency ω is substantially equal to the frequency Fac of the alternating-current voltage 11a (ω ≈ Fac), and is as far as possible from the frequency Fd of the discharge current pulse 31 (ω << Fd). With this, as shown in Fig. 13, the discharge current dispersion circuit 13 has generally minimum impedance Z4 with respect to the alternating-current voltage 11a having the frequency Fac, and has relatively large impedance Z3 with respect to the discharge current pulse 31 having the frequency Fd. Accordingly, the discharge current dispersion circuit 13 constituted of the LC series circuit functions as a so-called band-pass filter that selectively allows passing of the alternating-current voltage 11a having the frequency Fac. In the modification example, the resonance frequency ω and the frequency Fac of the alternating-current voltage 11a are about 200 kHz.

As described above, in a case where the discharge current dispersion circuit 13 is the LC series circuit, the discharge current dispersion circuit 13 simply functions as a band-pass filter, and in addition, as in a case where the discharge current dispersion circuit 13 is constituted of the LC parallel circuit, not only reduces the amplitude A1 of the discharge current pulse 31, but also stably generates another pulse, such as the second discharge current pulse 43, using energy for the reduction amount of the amplitude A1 of the discharge current pulse 31. As a result, the discharge current dispersion circuit 13 also stabilizes the generation of plasma in the plasma generation unit 12 even through the alternating-current voltage 11a is a high voltage, and the plasma input power is high. In a case where the discharge current dispersion circuit 13 has the LC series circuit as a basic configuration, as shown in Fig. 14, the resistor 101 can be added at any position in the discharge current dispersion circuit 13. That is, the discharge current dispersion circuit 13 can be a so-called RLC series circuit.

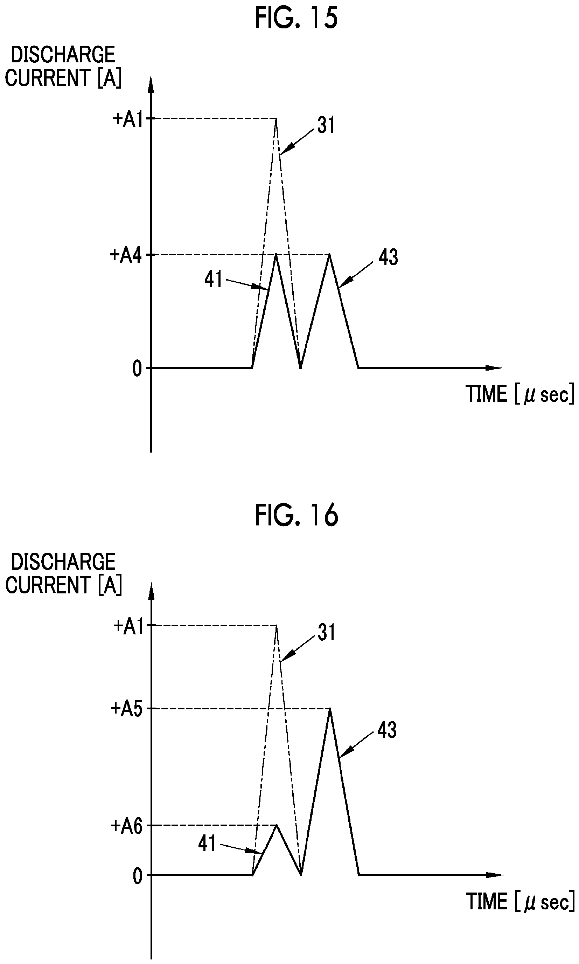

In the above-described embodiment and modification examples, although the amplitude A3 of the second discharge current pulse 43 is smaller than the amplitude A2 of the discharge current pulse 41 as the first discharge current pulse, the magnitude relationship of the amplitude can be altered by adjusting the inductance "L" of the inductor 21 and the capacitance "C" of the capacitor 22, or the like. For example, as shown in Fig. 15, the respective amplitude of the discharge current pulse 41 as a first discharge current pulse and the second discharge current pulse 43 can be set to substantially same amplitude A4. For example, as shown in Fig. 16, the amplitude of the second discharge current pulse 43 can be set to amplitude A5 greater than amplitude A6 of the discharge current pulse 41 as a first discharge current pulse (A6 < A5).

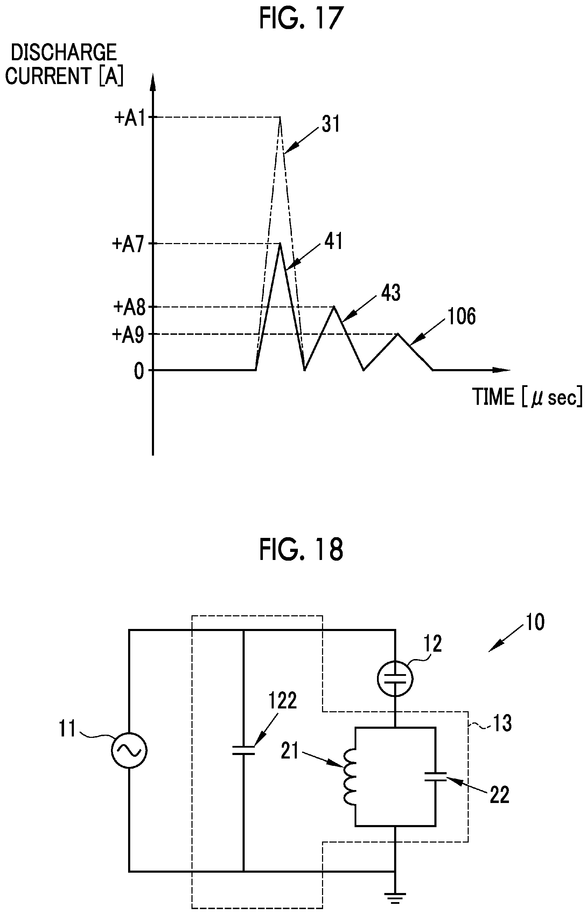

In the above-described embodiment and modification examples, although the original discharge current pulse 31, which is generated in a case where the discharge current dispersion circuit 13 is not used, is dispersed into the two pulses of the discharge current pulse 41 and the second discharge current pulse 43, as shown in Fig. 17, the discharge current dispersion circuit 13 may disperse the original discharge current pulse 31 into three pulses of the discharge current pulse 41, the second discharge current pulse 43, and a third discharge current pulse 106 by adjusting the inductance "L" of the inductor 21 and the capacitance "C" of the capacitor 22, or the like. Similarly, the discharge current dispersion circuit 13 can disperse the original discharge current pulse 31 into four or more pulses.

In addition to the above, as shown in Fig. 18, a capacitor 122 or the like can be included in the discharge current dispersion circuit 13, in addition to a circuit having a function of dispersing the discharge current pulse 31, such as an LC parallel circuit or an LC series circuit. The capacitor 122 is connected in parallel to an LC circuit part of the plasma generation unit 12 and the discharge current dispersion circuit 13, and suppresses harmonics.

As shown in the above-described embodiment and modification examples, the invention is particularly useful in a case where the difference between the frequency Fac of the alternating-current voltage 11a applied to the plasma generation unit 12 and the frequency Fd of the discharge current pulse 31 due to the generation of plasma is large, that is, in a case where the alternating-current voltage 11a having a low frequency is used. However, in a case where the alternating-current voltage 11a having a frequency higher than 1 MHz is used, the invention can be suitable used in a case where there is a difference between the frequency Fac of the alternating-current voltage 11a and the frequency Fd of the discharge current pulse 31 (Fac ≠ Fd).

### Explanation of References

10: atmospheric-pressure plasma generation device
11: alternating-current power supply
11a: alternating-current voltage
12: plasma generation unit
13: discharge current dispersion circuit
14A: first electrode
14B: second electrode
15: discharge space
16: dielectric
19: film
21: inductor
22, 122: capacitor
31: discharge current pulse
32: phase of alternating-current voltage
33: abnormal discharge current pulse
41: discharge current pulse after reduction
43: second discharge current pulse
101: resistor
106: third discharge current pulse
A1 to A6: amplitude of discharge current pulse
F1: frequency of discharge current pulse after reduction
F2: frequency of second discharge current pulse
Fac: frequency of alternating-current voltage
Fd: frequency of discharge current pulse
V1: amplitude of alternating-current voltage
X1: transport direction of film
Z1, Z2, Z3, Z4: impedance

## Claims

1. An atmospheric-pressure plasma generation circuit for use in an atmospheric-pressure plasma generation device (10), in which an alternating-current power supply (11) applies an alternating-current voltage between a pair of electrodes (14A,14B) in a plasma generation unit (12) under atmospheric pressure and the plasma generation unit (12) generates plasma, the atmospheric-pressure plasma generation circuit comprising:
a discharge current dispersion circuit (13) configured to be connected in series between the alternating-current power supply (11) and the plasma generation unit (12) and to disperse a pulse (31) of a discharge current into two or more pulses by reducing the amplitude A1 of the pulse (31) of the discharge current having a frequency higher than the frequency of the alternating-current voltage and generating another pulse (43) using a reduction amount of the amplitude A1 of the discharge current pulse (31);
wherein the discharge current dispersion circuit (13) is one of (i) an LC circuit having an inductor (21) and a capacitor (22), (ii) an RLC parallel circuit, (iii) an LC circuit with a resistor (101) connected in series to the capacitor (22), and (iv) an LC circuit with the resistor (101) connected in series to the inductor (21); and
**characterised in that**
the discharge current dispersion circuit (13) has the frequency of the pulse (31) of the discharge current before dispersion a resonance frequency.

2. The atmospheric-pressure plasma generation circuit according to claim 1,
wherein the discharge current dispersion circuit (13) is configured to disperse the pulse of the discharge current into two or more pulses having the same waveform in a case where the plasma generation unit (12) repeatedly generates the plasma.

3. The atmospheric-pressure plasma generation circuit according to claim 1 or 2,
wherein the pulse generated later in time out of the two or more pluses dispersed by the discharge current dispersion circuit (13) has a lower frequency.

4. The atmospheric-pressure plasma generation circuit according to any one of claims 1 to 3,
wherein the discharge current dispersion circuit (13) has impedance to transmit a frequency component of the alternating-current voltage and to reduce a frequency component of the discharge current.

5. The atmospheric-pressure plasma generation circuit according to any one of claims 1 to 4, wherein, in a case where the discharge current dispersion circuit (13) is one of (i) an LC circuit and (ii) an RLC parallel circuit, the discharge current dispersion circuit (13) comprises the inductor (21) connected in parallel with the capacitor (22).

6. The atmospheric-pressure plasma generation circuit according to any one of claims 1 to 4, wherein, in a case where the discharge current dispersion circuit (13) is one of (iii) an LC circuit with the resistor (101) connected in series to the capacitor (22) and (iv) an LC circuit with the resistor (101) connected in series to the inductor (21), the inductor is connected in series with the capacitor (22).

7. The atmospheric-pressure plasma generation circuit according to any one of claims 1 to 6,
wherein the alternating-current voltage has a frequency equal to or higher than 1 kHz and equal to or lower than 1 MHz.

8. An atmospheric-pressure plasma generation device (10) comprising:
an alternating-current power supply (11) configured to generate an alternating-current voltage;
a plasma generation unit (12) that has a pair of electrodes (14A,14B) and is configured to generate plasma in a case where the alternating-current voltage is applied between the pair of electrodes (14A,14B) under atmospheric pressure; and
the discharge current dispersion circuit (13) of any of claims 1 to 7.

9. An atmospheric-pressure plasma generation method comprising:
applying an alternating-current voltage between a pair of electrodes (14A,14B) in a plasma generation unit (12); and
dispersing a pulse of a discharge current into two or more pulses by reducing the amplitude A1 of a pulse (31) of the discharge current having a frequency higher than the frequency of the alternating-current voltage and generating another pulse using a reduction amount of the amplitude A1 of the discharge current pulse (31);
**characterised in that** the discharge current dispersion circuit has the frequency of the pulse (31) of the discharge current before dispersion as a resonance frequency.

## Patentansprüche

1. Erzeugungsschaltung für Plasma unter Atmosphärendruck zur Verwendung in einer Erzeugungsvorrichtung (10) für Plasma unter Atmosphärendruck, in welcher eine Wechselstromversorgung (11) eine Wechselspannung zwischen ein Paar Elektroden (14A, 14B) in einer Plasmaerzeugungseinheit (12) unter atmosphärischem Druck anlegt und die Plasmaerzeugungseinheit (12) Plasma erzeugt, umfassend:
eine Entladungsstrom-Dispersionsschaltung (13), konfiguriert zur Verschaltung zwischen der Wechselstromversorgung (11) und der Plasmaerzeugungseinheit (12) in Serie, und zum Dispergieren eines Impulses (31) eines Entladestroms in zwei oder mehr Impulse durch Verringern der Amplitude A1 des Impulses (31) des Entladestroms mit einer Frequenz höher als die Frequenz der Wechselspannung, und zum Erzeugen eines weiteren Impulses (43) unter Verwendung eines Verringerungsmaßes der Amplitude A1 des Entladestromimpulses (31);
wobei die Entladestrom-Dispersionsschaltung (13) (i) eine LC-Schaltung mit einer Induktivität (21) und einer Kapazität (22), (ii) eine RLC-Parallelschaltung, (iii) eine LC-Schaltung mit einem in Serie zu der Kapazität (22) geschalteten Widerstand (101), oder (iv) eine LC-Schaltung mit dem zu der Induktivität (21) in Serie geschalteten Widerstand (101) ist,
**dadurch gekennzeichnet, dass**
die Entladestrom-Dispersionsschaltung (13) die Frequenz des Impulses (31) des Entladestroms vor der Dispersion als Resonanzfrequenz aufweist.

2. Schaltung nach Anspruch 1,
bei der die Entladestrom-Dispersionsschaltung (13) konfiguriert ist zum Dispergieren des Impulses des Entladestroms in zwei oder mehr Impulse gleicher Wellenform für den Fall, dass die Plasmaerzeugungseinheit (12) das Plasma wiederholt erzeugt.

3. Schaltung nach Anspruch 1 oder 2,
bei der der von den zwei oder mehr Impulsen, die von der Entladestrom-Dispersionsschaltung (13) dispergiert wurden, spätere Impuls eine niedrigere Frequenz hat.

4. Schaltung nach einem der Ansprüche 1 bis 3,
bei der die Entladestrom-Dispersionsschaltung (13) eine Impedanz zum Senden einer Frequenzkomponente der Wechselspannung und zum Reduzieren einer Frequenzkomponente des Entladungsstroms besitzt.

5. Schaltung nach einem der Ansprüche 1 bis 4,
bei der für den Fall, dass die Entladestrom-Dispersionsschaltung (13) (i) eine LC-Schaltung oder (ii) eine RLC-Parallelschaltung ist, die Entladestrom-Dispersionsschaltung (13) die Induktivität (21) parallel zu der Kapazität (22) aufweist.

6. Schaltung nach einem der Ansprüche 1 bis 4,
bei der für den Fall, dass die Entladestrom-Dispersionsschaltung (13) (iii) eine LC-Schaltung mit dem zu der Kapazität (22) in Serie geschalteten Widerstand (101) oder (iv) eine LC-Schaltung mit dem in Serie zu der Induktivität (21) geschalteten Widerstand (101) ist, die Induktivität in Serie zu der Kapazität (22) geschaltet ist.

7. Schaltung nach einem der Ansprüche 1 bis 6,
bei der die Wechselspannung eine Frequenz gleich oder höher als 1 kHz und gleich oder kleiner als 1 MHz aufweist.

8. Erzeugungsvorrichtung (10) zum Erzeugen von Plasma unter atmosphärischem Druck, umfassend:
eine Wechselstromversorgung (11), konfiguriert zum Erzeugen einer Wechselspannung;
eine Plasmaerzeugungseinheit (12), die ein Paar Elektroden (14A, 14B) besitzt und konfiguriert ist zum Erzeugen von Plasma für den Fall, dass die Wechselspannung an das Paar von Elektroden (14A, 14B) unter Atmosphärendruck gelegt wird; und
die Entladestrom-Dispersionsschaltung (13) nach einem der Ansprüche 1 bis 7.

9. Erzeugungsverfahren zum Erzeugen von Plasma unter Atmosphärendruck, umfassend:
Anlegen einer Wechselspannung an ein Paar Elektroden (14A, 14B) in einer Plasmaerzeugungseinheit (12); und
Dispergieren eines Impulses eines Entladestroms in zwei oder mehr Impulse durch Verringern der Amplitude A1 eines Impulses (31) des Entladestroms mit einer Frequenz höher als die Frequenz der Wechselspannung, und zum Erzeugen eines weiteren Impulses unter Verwendung eines Verringerungsbetrags der Amplitude A1 des Entladestromimpulses (31);
**dadurch gekennzeichnet, dass** die Ladestrom-Dispersionsschaltung die Frequenz des Impulses (31) des Entladungsstroms vor der Dispersion als Resonanzfrequenz besitzt.

## Revendications

1. Circuit de génération de plasma à pression atmosphérique pour une utilisation dans un dispositif de génération de plasma à pression atmosphérique (10), où une alimentation électrique à courant alternatif (11) applique une tension alternative entre une paire d'électrodes (14A, 14B) dans une unité de génération de plasma (12) sous pression atmosphérique, et l'unité de génération de plasma (12) génère un plasma, le circuit de génération de plasma à pression atmosphérique comprenant :
un circuit de dispersion de courant de décharge (13) configuré pour être monté en série entre l'alimentation électrique à courant alternatif (11) et l'unité de génération de plasma (12), et pour disperser une impulsion (31) d'un courant de décharge en deux impulsions ou davantage en réduisant l'amplitude A1 de l'impulsion (31) du courant de décharge présentant une fréquence supérieure à la fréquence de la tension alternative et en générant une autre impulsion (43) à l'aide d'une quantité de réduction de l'amplitude A1 de l'impulsion de courant de décharge (31),
dans lequel le circuit de dispersion de courant de décharge (13) est l'un des éléments parmi (i) un circuit LC présentant une bobine d'induction (21) et un condensateur (22), (ii) un circuit parallèle RLC, (iii) un circuit LC présentant une résistance (101) montée en série avec le condensateur (22), et (iv) un circuit LC présentant la résistance (101) montée en série avec la bobine d'induction (21), et
**caractérisé en ce que** le circuit de dispersion de courant de décharge (13) présente la fréquence de l'impulsion (31) du courant de décharge avant dispersion comme fréquence de résonance.

2. Circuit de génération de plasma à pression atmosphérique selon la revendication 1,
dans lequel le circuit de dispersion de courant de décharge (13) est configuré pour disperser l'impulsion du courant de décharge en deux impulsions ou davantage présentant la même forme d'onde dans un cas où l'unité de génération de plasma (12) génère de manière répétée le plasma.

3. Circuit de génération de plasma à pression atmosphérique selon la revendication 1 ou 2,
dans lequel l'impulsion générée plus tard dans le temps parmi les deux impulsions ou davantage dispersées par le circuit de dispersion de courant de décharge (13) présente une fréquence inférieure.

4. Circuit de génération de plasma à pression atmosphérique selon l'une quelconque des revendications 1 à 3,
dans lequel le circuit de dispersion de courant de décharge (13) présente une impédance afin de transmettre une composante de fréquence de la tension alternative et réduire une composante de fréquence du courant de décharge.

5. Circuit de génération de plasma à pression atmosphérique selon l'une quelconque des revendications 1 à 4, dans lequel dans un cas où le circuit de dispersion de courant de décharge (13) est l'un des éléments parmi (i) un circuit LC et (ii) un circuit parallèle RLC, le circuit de dispersion de courant de décharge (13) comprend la bobine d'induction (21) montée en parallèle avec le condensateur (22).

6. Circuit de génération de plasma à pression atmosphérique selon l'une quelconque des revendications 1 à 4,
dans lequel dans un cas où le circuit de dispersion de courant de décharge (13) est l'un des éléments parmi (iii) un circuit LC présentant la résistance (101) montée en série avec le condensateur (22), et (iv) un circuit LC présentant la résistance (101) montée en série avec la bobine d'induction (21), la bobine d'induction est montée en série avec le condensateur (22).

7. Circuit de génération de plasma à pression atmosphérique selon l'une quelconque des revendications 1 à 6,
dans lequel la tension alternative présente une fréquence supérieure ou égale à 1 kHz et inférieure ou égale à 1 MHz.

8. Dispositif de génération de plasma à pression atmosphérique (10), comprenant :
une alimentation électrique à courant alternatif (11) configurée pour générer une tension alternative ;
une unité de génération de plasma (12), laquelle présente une paire d'électrodes (14A, 14B) et est configurée pour générer un plasma dans un cas où la tension alternative est appliquée entre la paire d'électrodes (14A, 14B) sous pression atmosphérique, et
le circuit dispersion de courant de décharge (13) selon l'une quelconque des revendications 1 à 7.

9. Procédé de génération de plasma à pression atmosphérique, comprenant les étapes suivantes :
appliquer une tension alternative entre une paire d'électrodes (14A, 14B) dans une unité de génération de plasma (12), et
disperser une impulsion d'un courant de décharge en deux impulsions ou davantage en réduisant l'amplitude A1 de l'impulsion (31) du courant de décharge présentant une fréquence supérieure à la fréquence de la tension alternative et en générant une autre impulsion à l'aide d'une quantité de réduction de l'amplitude A1 de l'impulsion de courant de décharge (31),
**caractérisé en ce que** le circuit de dispersion de courant de décharge présente la fréquence de l'impulsion (31) du courant de décharge avant dispersion comme fréquence de résonance.
